# EUROPEAN PATENT APPLICATION

(11) **EP 4 644 456 A1**
(43) Date of publication of application: **05.11.2025**
(21) Application number: 23911230.3
(22) Date of filing: 27.07.2023
(51) Int. Cl.: C08G 59/68, C09J 11/06, C09J 163/00, C09J 171/00, C09J 201/00, H01L 21/52

(54) **CURABLE RESIN COMPOSITION, ADHESIVE, SEALING MATERIAL, CURED PRODUCT, SEMICONDUCTOR DEVICE, AND ELECTRONIC DEVICE**

(30) Priority: 27.12.2022 JP 2022210519
(71) Applicant: Namics Corporation, Niigata-shi, Niigata 950-3131 (JP)
(72) Inventor: SUZUKI, Fumiya, Niigata-shi, Niigata 950-3131 (JP); IWAYA, Kazuki, Niigata-shi, Niigata 950-3131 (JP)
(74) Representative: Mathys & Squire
(86) International application number: PCT/JP2023/027618
(87) International publication number: WO 2024/142446

(57) **Abstract**

Provided are a curable resin composition, an adhesive, a sealing material that can be cured by heating at a low temperature and/or ultraviolet irradiation, and suppress corrosion of an adherend, a cured product obtained by curing them, and a semiconductor device and an electronic device including the cured product. The curable resin composition contains: (A) a cationically curable resin; (B) an acid generator containing an iodonium salt; and (C) an ion trapping agent containing at least one atom selected from the group consisting of Zr, Mg, and Al.

## Description

### TECHNICAL FIELD

The present invention relates to a curable resin composition, an adhesive, a sealing material, a cured product, a semiconductor device, and an electronic device.

### BACKGROUND ART

A curable resin composition containing a cationic polymerizable compound is used as an adhesive in the field of electronic devices because a cured product thereof is excellent in characteristics such as adhesiveness, electrical insulation properties, chemical resistance, and mechanical strength.

In a case where an adherend to be bonded is a member of a precision instrument such as a camera module or a sensor module, it is required that the adhesive can be cured by at least one of heating at a low temperature of, for example, 100°C or lower, preferably 80°C or lower, and/or ultraviolet irradiation. For example, PATENT LITERATURE 1 describes a thermal polymerization initiator system that allows curing by heating at a low temperature and contains, for example, an aryl group-containing iodonium salt compound for initiating a polymerization reaction of a cationic polymerizable compound, and a radical polymerization initiator that is an organic peroxide. Excess aryl iodide that is formed by decomposition of the iodonium salt compound and are not involved in the polymerization reaction may react with water vapor contained in an outside air to generate a gas that corrodes a metal. PATENT LITERATURE 1 describes an adhesive composition in which a corrosion inhibitor made of a metal hydroxide or a metal oxide can be added and mixed for the purpose of preventing corrosion of the adherend.

### CITATION LIST

### PATENT LITERATURE

PATENT LITERATURE 1: JP-A-2011-116977

### SUMMARY OF INVENTION

### PROBLEMS TO BE SOLVED BY INVENTION

However, addition of the corrosion inhibitor to the composition may reduce curability of the adhesive. In a case where different types of materials are often bonded as in the camera module or the sensor module, a composition that can be cured by at least one of heating at, for example, 100°C or lower and/or ultraviolet irradiation to bond the different types of materials may be required.

Therefore, an object of the present invention is to provide a curable resin composition, an adhesive, a sealing material that can be cured by at least one of heating at, for example, 100°C or lower and/or ultraviolet irradiation, and suppress the corrosion of the adherend, a cured product obtained by curing them, and a semiconductor device and an electronic device including the cured product.

### SOLUTION TO PROBLEMS

Means for solving the above problems are as follows, and the present invention includes the following aspects.
[1] A curable resin composition containing the following components (A) to (C):
   (A) a cationically curable resin;
   (B) an acid generator containing an iodonium salt; and
   (C) an ion trapping agent containing at least one atom selected from the group consisting of Zr, Mg, and A1.
[2] The curable resin composition according to the above [1], in which the component (C) is 0.1 to 15 parts by mass based on 1 part by mass of the component (B).
[3] The curable resin composition according to the above [1] or [2], in which the component (C) is a both ion exchange type ion trapping agent.
[4] The curable resin composition according to any one of the above [1] to [3], in which primary particles of the component (C) have an average particle size of 30 nm to 3000 nm.
[5] The curable resin composition according to any one of the above [1] to [4], in which the component (A) contains at least one selected from the group consisting of:
   (A1) an epoxy resin having an epoxy group equivalent of 100 g/eq to 1000 g/eq and having a ring skeleton in a molecule of the epoxy resin; and
   (A2) an oxetane resin.
[6] The curable resin composition according to any one of the above [1] to [5], further containing (D) an organic peroxide.
[7] The curable resin composition according to any one of the above [1] to [6], in which iodonium salt contained in the component (B) is an iodonium salt compound represented by the following Formula (1):

   Ar¹-I⁺-Ar^{2.}Z⁻ (1)

   (in Formula (1), Ar¹ and Ar² are each independently a substituted or unsubstituted aryl group, and Z⁻ is an anion).
[8] The curable resin composition according to the above [7], wherein Z⁻ in Formula (1) is BF₄⁻, SbF₆⁻, AsF₆⁻, B(C₆F₅)₄⁻, Ga(C₆F₅)₄⁻, C(CF₃SO₂)₃⁻, [P(R^{F})ₐF₆₋ₐ]⁻, [C(R^{F}SO₂)₃], or [N(R^{F}SO₂)₂]⁻ (where R^{F}s are each independently an alkyl group in which at least a part of hydrogen atoms is substituted with a fluorine atom, a is an integer of 0 to 5, and in a case where a is an integer of 2 or more, a plurality of R^{F}s may be the same or different from each other).
[9] An adhesive or a sealing material containing the curable resin composition according to any one of the above [1] to [8].
[10] A cured product obtained by curing the curable resin composition according to any one of the above [1] to [8], or the adhesive or the sealing material according to the above [9].
[11] A semiconductor device including the cured product according to the above [9] or [10].
[12] An electronic device including the cured product according to the above [9] or [10].

### EFFECTS OF INVENTION

According to the present invention, it is possible to provide a curable resin composition, an adhesive, a sealing material that can be cured while suppressing a decrease in curability by at least one of heating at, for example, 100°C or lower and/or ultraviolet irradiation, and suppress the corrosion of the adherend, a cured product obtained by curing them, and a semiconductor device and an electronic device including the cured product.

### DESCRIPTION OF EMBODIMENTS

Hereinafter, a curable resin composition, an adhesive, a sealing material, a cured product obtained by curing them, a semiconductor device and an electronic device including the cured product according to the present disclosure will be described based on embodiments. However, the following embodiments are examples for embodying a technical idea of the present invention, and the present invention is not limited to the following curable resin composition, adhesive, sealing material, cured product, semiconductor device, and electronic device. In the present specification, following the convention in the field of synthetic resins, for a component constituting a curable resin composition before curing, a name including a term "resin" usually indicating a polymer (particularly a synthetic polymer) may be used although the component is not a polymer.

### Resin composition

The curable resin composition according to a first embodiment of the present invention is a curable resin composition containing: (A) a cationically curable resin (hereinafter, also referred to as "component (A)"); (B) an acid generator containing an iodonium salt (hereinafter, also referred to as "component (B)"); and (C) an ion trapping agent containing at least one atom selected from the group consisting of Zr, Mg, and Al (hereinafter, also referred to as "component (C)").

When the curable resin composition is heated, the iodonium salt is decomposed to generate protonic acid H⁺X⁻. This protonic acid is coordinated to a functional group of the cationically curable resin, and the functional group to which the protonic acid is coordinated is attacked by a functional group of another cationically curable resin to generate a cation to be an active species, and a polymerization reaction proceeds. In a case of an iodonium salt compound containing an iodonium substituted with an aryl group, an aryl iodide generated by decomposition of the iodonium salt by heating reacts with water vapor in the air to generate a corrosive gas (hydrogen iodide). Therefore, corrosive gas (hydrogen iodide) is trapped by the ion trapping agent containing at least one atom selected from the group consisting of Zr, Mg, and Al, and release of a gas that corrodes a metal is suppressed. Since the release of the corrosive gas generated by reaction of the aryl iodide generated from the iodonium salt after heating with the water vapor is suppressed, corrosion of an adherend can be suppressed when the curable resin composition is cured.

### Component (A): Cationically curable resin

The cationically curable resin of the component (A) refers to a resin having one or more cationically polymerizable groups in a molecule of the resin. Examples of the cationically polymerizable group include an epoxy group, an oxetanyl group, and a vinyl ether group. Examples of the cationically curable resin include epoxy resins, oxetane resins, polystyrene-based compounds, and vinyl ether compounds. The cationically curable resin of the component (A) preferably has a molecular weight of 100 to 800 and may have a molecular weight of 110 to 780 in order to obtain a cured product that is cured by heating at a low temperature of 100°C or lower, preferably 80°C or lower, and/or ultraviolet irradiation.

The cationically curable resin of the component (A) preferably contains at least one selected from the group consisting of (A1) an epoxy resin having an epoxy group equivalent of 100 g/eq to 1000 g/eq and having a ring skeleton in a molecule of the epoxy resin (hereinafter, also referred to as "component (A1)"), and (A2) an oxetane resin (hereinafter, also referred to as "component (A2)"). When the component (A) contains at least one selected from the group consisting of the component (A1) the epoxy resin having a ring skeleton in the molecule and (A2) the oxetane resin, the curable resin composition can be heated at, for example, 100°C or lower, preferably 80°C or lower to obtain a cured product. The component (A) may contain the component (A1) alone, or may contain both the component (A1) and the component (A2). The number of functional group equivalents such as the number of epoxy group equivalents and the number of oxetane group equivalents described later represents the number of functional groups (equivalent number) per mass (charged amount) of compound.

Examples of the epoxy resin include an aliphatic epoxy resin and an epoxy resin having a ring skeleton in the molecule. The epoxy resin preferably contains an epoxy resin having a ring skeleton in the molecule. Examples of the ring skeleton include an alicyclic skeleton, an aromatic ring skeleton, a heteroaromatic ring skeleton, and a heterocyclic skeleton. The epoxy resin having a ring skeleton in the molecule preferably contains at least one selected from the group consisting of an epoxy resin having an aromatic ring skeleton in the molecule and an epoxy resin having an alicyclic skeleton in the molecule, and more preferably contains the epoxy resin having an aromatic ring skeleton.

Specific examples of the epoxy resin having an aromatic ring skeleton include, as a polyfunctional epoxy resin, a bisphenol A type epoxy resin (EPICLON (registered trademark) 850, 850-S, EXA-850CRP, EXA-8067, and the like manufactured by DIC Corporation), a special epoxy resin containing a compound, in which a polyalkylene oxide structure is added to an epoxy resin and a bisphenol A skeleton (AER9000 manufactured by Asahi Kasei Corporation, EP-4000S, EP-4003S, and EP-4010S manufactured by ADEKA Corporation), a phenol F type epoxy resin (EPICRON (registered trademark) 830-S, EXA-830LVP, and the like manufactured by DIC Corporation), a bisphenol AD type epoxy resin, a bisphenol S type epoxy resin, a naphthalene type epoxy resin (EPICRON (registered trademark), HP-4032D, HP-720H, and the like manufactured by DIC Corporation), a phenol novolac type epoxy resin (EPICLON (registered trademark) N-740, N-770, and the like manufactured by DIC Corporation), and a cresol volac type epoxy resin (EPICRON (registered trademark), N-660, N-670, N-655-EXP-S, and the like manufactured by DIC Corporation). Specific examples of a polyfunctional epoxy compound contained in the polyfunctional epoxy resin include glycidyl ether of tetra(hydrophenyl)alkane, glycidyl ether of tetrahydroxybenzophenone, and epoxidized polyvinyl phenol. In a monofunctional epoxy resin, examples of a compound contained in the monofunctional epoxy resin include p-tert-butyl phenyl glycidyl ether (ADEKA GLYCILOL (registered trademark), ED-509E, ED-509 S, and the like manufactured by ADEKA Corporation).

The epoxy resin having an alicyclic skeleton only needs to have an alicyclic skeleton in one molecule, and includes a cycloalkylene oxide compound, in which an epoxy group is formed by two carbon atoms and one oxygen atom forming an alicyclic structure. The epoxy resin having an alicyclic skeleton may contain an epoxy compound having an alicyclic skeleton. Examples of the epoxy compound having an alicyclic skeleton include cyclohexane-based, cyclohexyl methyl ester-based, cyclohexyl methyl ether-based, spiro-based, and tricyclodecane-based epoxy compounds. Specific examples of the epoxy resin having an alicyclic skeleton include 3',4'-epoxycyclomethyl-3,4-epoxycyclohexanecarboxylate (CELLOXIDE (registered trademark) 2021P and the like manufactured by Daicel Corporation), (3,3',4,4'-diepoxy)bicyclohexyl (CELLOXIDE (registered trademark) 8010 and the like manufactured by Daicel Corporation), 1,2:8,9-diepoxylimonene, 1,2-epoxy-4-vinylcyclohexane, and 1,2-epoxy-4-(2-oxiranyl)cyclohexane adduct of 2,2-bis(hydroxymethyl)-1-butanol (EHPE3150 and the like manufactured by Daicel Corporation).

Examples of the aliphatic epoxy resin include polyglycidyl ethers of polyhydric alcohols or alkylene oxide adducts thereof. Specific examples of an aliphatic epoxy compound contained in the aliphatic epoxy resin include ethylene glycol diglycidyl ether, diethylene glycol diglycidyl ether, propylene glycol diglycidyl ether, 1,4-butanediol diglycidyl ether, neopentyl glycol diglycidyl ether, 1,6-hexanediol diglycidyl ether, glycerin diglycidyl ether, trimethylolpropane triglycidyl ether (such as Epolite 100MF manufactured by Kyoeisha Chemical Co., Ltd.), and polyethylene glycol diglycidyl ether. Examples of an aliphatic cyclic epoxy resin include hydrogenated bisphenol A diglycidyl ether (such as jER YX8000 manufactured by Mitsubishi Chemical Corporation).

Specific examples of the vinyl ether compound include hydroxybutyl vinyl ether, vinyl ether of 1,4-cyclohexanedimethanol, triethylene glycol divinyl ether, dodecyl vinyl ether, and cyclohexyl vinyl ether.

In a case where the component (A) contains an epoxy resin having an epoxy group equivalent of component (A1) of 100 g/eq to 1000 g/eq and a ring skeleton in the molecule, when the epoxy group equivalent of the epoxy resin contained in the component (A) is 100 g/eq to 1000 g/eq, a cured product cured by heating at a low temperature of, for example, 100°C or lower, preferably 80°C or lower, and/or ultraviolet irradiation is obtained. In a case where the component (A) contains an epoxy resin of the component (A1), the epoxy group equivalent of the epoxy resin may be 800 g/eq or less, 600 g/eq or less, 500 g/eq or less, 400 g/eq or less, 120 g/eq or more, 130 g/eq or more, 150 g/eq or more, 180 g/eq or more, or 200 g/eq or more.

The oxetane resin of the component (A2) undergoes a polymerization initiation reaction slower than that of the epoxy resin, but is polymerized at a high speed when concentration of a polymerization initiating species is a certain level or more, and thus the cured product is obtained by a reaction in a short time at a low temperature. Specific examples of the oxetane resin include 3-ethyl-3-hydroxymethyloxetane (oxetane alcohol) (such as OXT-101 manufactured by Toagosei Co., Ltd.), 2-ethylhexyl oxetane (such as OXT-212 manufactured by Toagosei Co., Ltd.), xylylene bisoxetane (such as OXT-121 manufactured by Toagosei Co., Ltd.), 3-ethyl-3-{[(3-ethyloxetane-3-yl)methoxy]methyl}oxetane (such as OXT-221 manufactured by Toagosei Co., Ltd.), oxetanyl silsesquioxetane (such as OXT-191 manufactured by Toagosei Co., Ltd.), phenol novolac oxetane (such as PHOX manufactured by Toagosei Co., Ltd.), and 3-ethyl-3-phenoxymethyloxetane (such as OXT-211 manufactured by Toagosei Co., Ltd.).

In a case where the component (A) contains the oxetane resin of the component (A2), the oxetane group equivalent of the oxetane resin is preferably 100 g/eq to 500 g/eq, and may be 110 g/eq to 300 g/eq. In a case where the oxetane resin of the component (A2) is contained in the component (A), when the oxetane group equivalent of the component (A2) is 100 g/eq to 500 g/eq, the cured product cured by heating at a low temperature of, for example, 100°C or lower, preferably 80°C or lower, and/or ultraviolet irradiation is obtained. In a case where the component (A) contains the oxetane resin of the component (A2), the oxetane group equivalent of the oxetane resin may be 250 g/eq or less.

### Component (B): Acid generator containing iodonium salt

The iodonium salt contained in the acid generator of the component (B) is preferably an iodonium compound represented by the following Formula (1):

Ar¹-I⁺-Ar^{2.}Z⁻ (1)

(in Formula (1), Ar¹ and Ar² are each independently a substituted or unsubstituted aryl group, and Z⁻ is an anion).

The aryl group represents an aromatic hydrocarbon group having 6 to 18 carbon atoms, and examples thereof include a phenyl group, a naphthyl group, and an anthracenyl group. Ar¹ and Ar² in Formula (1) are each independently preferably a phenyl group or a naphthyl group. The aryl group may be unsubstituted or substituted with one or more optional substituents. Examples of the substituent include a linear or branched alkyl group having 1 to 18 carbon atoms, a linear or branched alkoxy group having 1 to 18 carbon atoms, a linear or branched acyloxy group having 2 to 18 carbon atoms, a halogen atom, a cyano group, a nitro group, and a hydroxyl group.

The anion only needs to be a monovalent counter anion, and is preferably a non-antimony-based anion. In Formula (1), the anion represented by Z⁻ is preferably BF₄⁻, SbF₆⁻, AsF₆⁻, B(C₆F₅)₄⁻, Ga(C₆F₅)₄⁻, C(CF₃SO₂)₃⁻, [P(RF)ₐF₆₋ₐ]⁻, [C(R^{F}SO₂)₃]⁻, or [N(R^{F}SO₂)₂]⁻ (where R^{F}s are each independently an alkyl group in which at least a part of hydrogen atoms is substituted with a fluorine atom, a is an integer of 0 to 5, and in a case where a is an integer of 2 or more, a plurality of R^{F}_{S} may be the same or different from each other). In Formula (1), nucleophilicity of the anion represented by Z⁻ is preferably relatively low, and when the nucleophilicity of the anion contained in the iodonium salt is low, rate of growth reaction of the cationically curable resin is high, and the cured product can be obtained in a short time by heating at a low temperature of 100°C or lower and/or ultraviolet irradiation.

Specific examples of the component (B) include diphenyliodonium hexafluoroarsenate, di(4-chlorophenyl)iodonium hexafluoroarsenate, di(4-bromphenyl)iodonium hexafluoroarsenate, phenyl(4-methoxyphenyl)iodonium hexafluoroarsenate, 4-methylphenyl-4-(1-methylethyl)phenyliodonium hexafluorophosphate, 4-methylphenyl-4-(1-methylethyl)phenyliodonium tri(pentafluoroethyl)trifluorophosphate (for example, IK-1 manufactured by San-Apro Ltd.), 4-methylphenyl-4-(1-methylethyl)phenyliodonium tetrakis(pentafluorophenyl) borate, 4-methylphenyl-4-(2-methylpropyl)phenyliodonium hexafluorophosphate (for example, IRGACURE (registered trademark) 250 manufactured by BASF SE), bis(C₁₀₋₁₄-alkylphenyl)iodonium hexafluorophosphate (for example, WPI-113 manufactured by FUJIFILM Wako Pure Chemical Corporation), 4-methylphenyl-4-(1-methylethyl) phenyliodonium hexafluoroantimonate (for example, WPI-116 and the like manufactured by FUJIFILM Wako Pure Chemical Corporation), IK-1FG (manufactured by San-Apro Ltd.), and 4-isopropyl-4'-methyldiphenyliodonium tetrakis(pentafluorophenyl)borate (for example, Bluesil (registered trademark) P12074 and the like manufactured by ELKEM SILICONES). As such an iodonium salt, for example, a commercially available product can be used as a cationic initiator or as the iodonium salt contained in the acid generator.

### Component (C): Ion trapping agent

The ion trapping agent of the component (C) contains at least one atom selected from the group consisting of Zr, Mg, and Al, and is preferably a layered compound. The layered compound has a structure in which a part of Zr²⁺ or Mg²⁺ is substituted with Al³⁺, so that an interlayer is positively charged, can interact with an anion, and has a property of ion trapping between layers. Therefore, the ion trapping agent of the component (C) containing at least one atom selected from the group consisting of Zr, Mg, and Al and being a layered compound is preferable because it can trap iodide ions having a large ionic radius. On the other hand, it is considered that an ion trapping agent containing Bi or Sb, which is not a layered compound, cannot trap the iodide ions having a large ionic radius. In a case where the ion trapping agent of the component (C) is a layered compound containing at least one atom selected from the group consisting of Zr, Mg, and Al, an interlayer distance is preferably about 4Å to 13Å.

The component (C) is preferably a both ion exchange type ion trapping agent. In a case where the component (C) is the both ion exchange type ion trapping agent, it is considered that not only iodide ions can be trapped, but also weak acids that may inhibit cationic polymerization can be trapped, so that the polymerization reaction can be efficiently progressed. Therefore, a decrease in curability of the cationically curable resin can be suppressed.

In a case where the ion trapping agent of the component (C) is a layered compound and contains at least one atom selected from the group consisting of Zr, Mg, and Al, a commercially available product can be used. Examples of the ion trapping agent of the component (C) include Zr, Mg, and Al-based inorganic ion trapping agents (IXEPLAS (registered trademark)-A1, IXEPLAS (registered trademark)-A2, and the like manufactured by Toagosei Co., Ltd.), hydrotalcite (manufactured by FUJIFILM Wako Pure Chemical Corporation, and the like), and Mg, Al-based inorganic anion trapping agents (IXE-700F and the like manufactured by Toagosei Co., Ltd. and SWMNA-010-1, SWMNA-050-1, and the like manufactured by Toda Kogyo Co., Ltd.).

Hydrotalcite represented by the following Formula (2) can be used.

MgₚAl_{q}(OH)ᵤ(CO₃)ᵣ·nH₂O (2)

(in Formula (2), p, q, r, and s are positive numbers and satisfy 2p + 3q - r - 2s = 0, and n represents the number of hydrates and is 0 or a positive number).

Examples of the hydrotalcite include Mg_{4.5}Al₂(OH)₁₃CO₃·3.5H₂O, Mg₅Al_{1.5}(OH)_{12.5}CO₃·3.5H₂O, Mg₆Al₂(OH)₁₆CO₃·4H₂O,Mg_{4.2}Al₂(OH)_{12.4}CO₃·3.5H₂O, Mg_{4.3}Al₂(OH)_{12.6}CO₃·3.5H₂O, Mg_{4.2}Al₂(OH)_{12.4}CO₃-2.5H₂O, Mg_{4.2}Al₂(OH)_{12.4}CO₃·H₂O, and Mg₄Al₂(OH)₁₂CO₃·3.5H₂O.

In the ion trapping agent of the component (C), an average particle size of primary particles is preferably 30 nm to 3000 nm, more preferably 50 nm to 2500 nm, still more preferably 100 nm to 2000 nm, still more preferably 150 nm to 1500 nm, and yet still more preferably 200 nm to 1000 nm. The average particle size of the primary particles of the ion trapping agent of the component (C) refers to an arithmetic average value of 50 arbitrary primary particles measured by SEM image analysis observed with a scanning electron microscope (SEM). In a case where a commercially available product is used as the ion trapping agent of the component (C), the average particle size of the primary particles may be a catalog value.

### (D): Organic peroxide

The curable resin composition preferably further contains (D) an organic peroxide (hereinafter, also referred to as "component (D)"). The organic peroxide of the component (D) is preferably a peroxydicarbonate-type organic peroxide. Among organic peroxides, the peroxydicarbonate-type organic peroxide of the component (D) generates carbonate radicals. The generated carbonate radicals react quickly to extract hydrogen from other compounds contained in the curable resin composition, and unstable alkyl radicals such as primary alkyl radicals are generated from the carbonate radicals. Since the unstable alkyl radicals are highly reactive and prone to radical redox reactions, it is considered that a reaction rate of the radical redox reaction is faster than that of curing inhibition by oxygen. Therefore, it is considered that the peroxydicarbonate-type organic peroxide of the component (D) can rapidly progress a curing reaction of the cationically curable resin.

When the curable resin composition contains the peroxydicarbonate-type organic peroxide as the organic peroxide of the component (D), it can be cured by heating at a low temperature of, for example, 100°C or lower, preferably 80°C or lower.

In a case where the curable resin composition contains the organic peroxide of the component (D), even when a resin having a large functional group equivalent is used as the cationically curable resin, the curing reaction of the cationically curable resin can be rapidly progressed to obtain the cured product cured by heating at a low temperature of, for example, 100°C or lower, preferably 80°C or lower.

In a case where the organic peroxide of the component (D) is the peroxydicarbonate-type organic peroxide, the organic peroxide has a structure represented by -O-C(=O)-O-O-C(=O)-O-. The component (D) is a radical source, and in a case where the component (D) is the peroxydicarbonate-type organic peroxide, carbonate radicals are easily generated without accompanying a decarboxylation reaction. A one-hour half-life temperature of the organic peroxide of the component (D) is preferably 50°C to 80°C, may be 55°C to 75°C, and is preferably 55°C to 70°C. When the one-hour half-life temperature of the organic peroxide of the component (D) is 50°C to 80°C, even in a case where a thin-film cured product having a thickness of, for example, 100 µm or less is obtained by generating radicals by heating at a low temperature of 100°C or lower and reductively decomposing the iodonium salt, the curing inhibition by oxygen is suppressed and the polymerization reaction of the cationically curable resin can be promoted. The organic peroxide of the component (D) preferably has a molecular weight of 180 to 1000, and may have a molecular weight of 200 to 800 or 220 to 700 or less. When the organic peroxide of the component (D) has a molecular weight of 180 to 1000, the polymerization reaction can be carried out by heating at a low temperature of, for example, 100°C or lower, preferably 80°C or lower.

In a case where the component (D) is the peroxydicarbonate-type organic peroxide, examples thereof include di(secondary butyl) peroxydicarbonate (for example, Lupelox 225 and the like manufactured by ARKEMA Yoshitomi, Ltd.), dicetyl peroxydicarbonate (for example, Perkadox 24L and the like manufactured by Nouryon), and di(4-tert-butylcyclohexyl) peroxydicarbonate (for example, PEROYL TCP and the like manufactured by NOF CORPORATION). Examples of the component (D) include 1,1,3,3-tetramethylbutylperoxy-2-ethylhexanoate (for example, PEROCTA O and the like manufactured by NOF CORPORATION).

The curable resin composition may contain at least one selected from the group consisting of (E) a photosensitizer, (F) a photoradical generator, and (G) a filler (hereinafter, also respectively referred to as "component (E)", "component (F)", and "component (G)"). The curable resin composition may further contain at least one selected from the group consisting of (H) a coupling agent and (I) a colorant such as a pigment (hereinafter, also respectively referred to as "component (H)" and "component (I)"). At least one component selected from the group consisting of (H) the coupling agent and (I) the colorant may be contained as an optional component.

### (E) Photosensitizer

The photosensitizer is a component for increasing sensitivity of the iodonium salt to light. Examples of the photosensitizer include thioxanthone derivatives, carbonyl compounds, organic sulfur compounds, persulfides, redox-based compounds, azo and diazo compounds, halogen compounds, and photoreducible coloring matter, and the thioxanthone derivatives are preferable. Specific examples of the thioxanthone derivatives include isopropylthioxanthone, 2,4-diethylthioxanthone, 2-chlorothioxanthone, 2,4-diethylthioxanthone, 2-chlorothioxanthone, and thioxanthone ammonium salt, and 2,4-diethylthioxanthone is preferable.

### (F) Photoradical generator

The photoradical generator is a radical source together with the organic peroxide of the component (D), generates an alkyl radical by irradiation with light, reductively decomposes the iodonium salt, generates an acid (a cation: H⁺) by light, and promotes the polymerization reaction. In a case where the curable resin composition of the present invention contains the peroxydicarbonate-type organic peroxide as the organic peroxide of the component (D), it does not need to contain the photoradical generator (F). In a case where the curable resin composition contains the photoradical generator (F), the alkyl radical is produced by light to reductively decompose the iodonium salt, and the acid (cation: H⁺) is also produced by light to further promote the polymerization reaction. Examples of the photoradical generator include 1-hydroxycyclohexyl phenyl ketone (for example, Omnirad (registered trademark) 184 and the like manufactured by IGM Resins), 1-[4-(2-hydroxyethoxy)-phenyl]-2-hydroxy-2-methyl-1-propane-1-one, 2-hydroxy-1-{4-[4-(2-hydroxy-2-methyl-propionyl)-benzyl]phenyl} -2-methyl-propane-1-one, and 2-hydroxy-2-methyl-1-phenylpropane-1-one.

### (G) Filler

The filler is a component for improving fluidity, injectability, coatability, adhesiveness, and the like of the curable resin composition. When the filler is contained in the curable resin composition, a cured product cured into a thin film so as to have a thickness of, for example, 100 µm or less, preferably 50 µm or less is obtained. Examples of the filler include known inorganic fillers or organic fillers. The filler may be used alone or in combination of two or more kinds.

Examples of the inorganic filler include calcium carbonate, magnesium carbonate, barium sulfate, magnesium sulfate, aluminum silicate, titanium oxide, alumina, zinc oxide, silicon dioxide (precipitated silica, fumed silica, and the like), kaolin, talc, glass beads, sericite activated clay, aluminum hydroxide, asbestos powder, copper oxide, copper hydroxide, iron oxide, lead oxide, magnesium oxide, tin oxide, carbon, mica, smectite, carbon black, bentonite, aluminum nitride, and silicon nitride. The filler may be added as a thixotropic agent, and the fumed silica is preferable in a case where the filler is added as the thixotropic agent. The fumed silica may be surface treated. Examples of a surface treatment agent of an inorganic thixotropic agent include monoalkyltrialkoxysilane, dimethyldichlorosilane, polydimethylsiloxane, and hexamethyldisilazane. As the surface-treated or untreated fumed silica, a commercially available product can be used. The inorganic filler is preferably silicon dioxide, glass beads, or talc from the viewpoint of adhesiveness, and more preferably silicon dioxide from the viewpoint of improving fluidity, injectability, and coatability. Examples of the silicon dioxide include colloidal silica, hydrophobic silica (for example, Cabosil (registered trademark) TS720 and the like manufactured by Cabot Japan K.K.), spherical silica (for example, high purity synthetic spherical silica SE5200SEE and the like manufactured by Admatechs Co., Ltd.), and nanosilica. As for silicon dioxide, two or more kinds having different types or different particle sizes may be used in combination, or one kind may be used alone.

Examples of the organic filler include acrylic particles, polymethyl methacrylate, polystyrene (polystyrene beads), a copolymer obtained by copolymerizing a monomer constituting them (that is, methyl methacrylate or styrene) with another monomer, polyethylene particles, polysiloxane resin particles, polyamide particles, polyester fine particles, polyurethane fine particles, and rubber fine particles (acrylic rubber particles, isoprene rubber particles). The organic filler may have a core-shell structure. From the viewpoint of adhesiveness, the organic filler is preferably the rubber fine particles, and particularly preferably the rubber fine particles having a core-shell structure. In a case where the filler is the organic filler, a weight average molecular weight of the organic filler is not particularly limited, but is preferably 50,000 to 4,000,000, and particularly preferably 300,000 to 3,000,000.

The average particle size of the filler is not particularly limited, but is preferably 0.01 µm or more and less than 10 µm, and particularly preferably 0.012 µm or more and 5 µm or less in order to improve fluidity, injectability, coatability, adhesiveness, and the like. The average particle size of the filler can be measured by a laser diffraction type particle size distribution measuring apparatus, a dynamic light scattering type Nanotrac particle size distribution analyzer, or the like. The average particle size may be a 50% cumulative particle size in a volume-based particle size distribution or a 50% cumulative particle size in a number-based particle size distribution.

### (H) Coupling agent

The coupling agent has two or more different functional groups in the molecule, one of which is a functional group chemically bonded to an inorganic material, and the other is a functional group chemically bonded to an organic material. When the curable resin composition contains the coupling agent, the adhesiveness of the curable resin composition can be improved in a case where different types of materials such as a camera module and a sensor module are bonded.

Examples of the coupling agent include a silane coupling agent, an aluminum coupling agent, and a titanium coupling agent, but are not limited thereto. The coupling agent may be used alone or in combination of two or more kinds.

Examples of a functional group of the silane coupling agent include a vinyl group, an epoxy group, a styryl group, a methacrylic group, an acrylic group, an amino group, an isocyanurate group, a ureido group, a mercapto group, a sulfide group, and an isocyanate group. Examples of the silane coupling agent include: silane compounds having an epoxy group and an alkoxy group, and optionally having an alkyl group, such as 2-(3,4-epoxycyclohexyl)ethyltrimethoxysilane 3-glycidoxypropyltrimethoxysilane, 3-glycidoxypropylmethyldiethoxysilane, 3-glycidoxypropyltriethoxysilane; silane compounds having an alkenyl group and an alkoxy group and optionally having an alkyl group, such as vinyltrimethoxysilane and p-styryltrimethoxysilane; silane compounds having a (meth)acrylic group and an alkoxy group and may have an alkyl group, such as 3-methacryloxypropylmethyldimethoxysilane, 3-methacryloxypropyltrimethoxysilane, 3-methacryloxypropylmethyldiethoxysilane, 3-methacryloxypropyltriethoxysilane, and 3-acryloxypropyltrimethoxysilane; silane compounds having a primary or secondary amino group and an alkoxy group, and optionally having an alkyl group, such as N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; and silane compounds having one or more groups selected from the group consisting of a mercapto group, an isocyanato group, a ureido group, and a halogen atom, and one or more alkoxy groups, and optionally having an alkyl group, such as 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, and 3-isocyanatopropyltriethoxysilane.

### (I) Colorant

The colorant can be used for the purpose of coloring the curable resin composition. As the colorant, for example, a pigment, a dye, a coloring matter, or the like can be used. As the colorant, known colorants such as red, blue, green, yellow, black, and white can be used, and examples of the black colorant include carbon black-based, graphite-based, iron oxide-based, titanium black, anthraquinone-based, cobalt oxide-based, copper oxide-based, manganese-based, antimony oxide-based, nickel oxide-based, perylene-based, aniline-based, molybdenum sulfide, and bismuth sulfide. Examples of the pigment as a commercially available product include titanium blacks 13M, 13M-C, and 13M-T manufactured by Mitsubishi Materials Electronic Chemicals Co., Ltd.

Examples of the optional component of the curable resin composition include, in addition to the coupling agent (H) or the colorant (I), an additive, a leveling agent, an antioxidant, an antifoaming agent, a thixotropic agent, a viscosity modifier, a flame retardant, a colorant, a solvent, and the like.

The component (A) in the curable resin composition is preferably 40 to 95 mass%, more preferably 45 to 90 mass%, and still more preferably 50 to 85 mass% based on 100 mass% of total amount of the curable resin composition. When the content of the component (A) in the curable resin composition is 40 to 90 mass% based on 100 mass% of the total amount of the curable resin composition, the cured product can be obtained by heating at a low temperature of, for example, 100°C or lower, preferably 80°C or lower, and/or ultraviolet irradiation.

In a case where the curable resin composition contains, as the component (A), at least one selected from the group consisting of the component (A1) that is the epoxy resin having a ring skeleton having an epoxy group equivalent of 100 g/eq to 1000 g/eq in the molecule and the component (A2) that is the oxetane resin, a total amount of the component (A1) and the component (A2) is preferably 20 to 100 mass%, more preferably 30 to 90 mass%, and still more preferably 30 to 70 mass% when a total amount of the component (A) is 100 mass%. In order to obtain a cured product having a low elastic modulus, when the total amount of component (A) is 100 mass%, the component (A) may all be at least one component selected from the group consisting of the component (A1) and the component (A2) (the total amount of the component (A1) and the component (A2) is 100 mass%). In a case where the total amount of the component (A1) and the component (A2) is less than 100 mass% in the component (A), the remainder excluding the component (A1) and the component (A2) may be at least one selected from the group consisting of an epoxy resin having no ring skeleton in the molecule (for example, an aliphatic epoxy resin), a polystyrene-based compound, and a vinyl ether compound.

In a case where the component (A) in the curable resin composition contains the epoxy resin having a ring skeleton having an epoxy group equivalent of 100 g/eq to 1000 g/eq in the molecule of the component (A1), in order to obtain the cured product cured by heating at a low temperature of, for example, 100°C or lower, preferably 80°C or lower, and/or ultraviolet irradiation, a ratio 1 of the number of epoxy group equivalents in the epoxy resin of the component (A1) to the number of functional group equivalents contained in the component (A) (functional group equivalent ratio 1 = [number of epoxy group equivalents in the component (A1) having a ring skeleton having an epoxy group equivalent of 100 g/eq to 1000 g/eq in the molecule/number of functional group equivalents in the component (A)]) is preferably 0.01 to 1.0, more preferably 0.2 to 0.9, and still more preferably 0.4 to 0.8.

In the component (A) in the curable resin composition, the oxetane resin of the component (A2) is preferably 0 to 40 mass%, more preferably 0 to 30 mass%, and still more preferably 0 to 20 mass% when the total amount of the component (A) is 100 mass%. In a case where the oxetane resin of the component (A2) is contained in the component (A), the cured product cured by heating at a low temperature of, for example, 100°C or lower, preferably 80°C or lower, and/or ultraviolet irradiation can be obtained.

In a case where the component (A) in the curable resin composition contains the oxetane resin of the component (A2), in order to obtain the cured product cured by heating at a low temperature of, for example, 100°C or lower, preferably 80°C or lower, and/or ultraviolet irradiation, a ratio 2 of the number of oxetane group equivalents in the oxetane resin of the component (A2) to the number of functional group equivalents contained in the component (A) (functional group equivalent ratio 2 = [number of oxetane group equivalents in the component (A2)/number of functional group equivalents in the component (A)] is preferably 0.01 to 0.8, more preferably 0.1 to 0.6, and still more preferably 0.1 to 0.4.

A blending ratio of the component (A1) to the component (A2) in the component (A) in the curable resin composition (component (A1):component (A2)) is preferably 100:0 to 60:40, more preferably 99:1 to 70:30, and still more preferably 98:2 to 80:20 in mass ratio. When the blending ratio of the component (A1) to the component (A2) in the component (A) is 100:0 to 60:40, the cured product cured by heating at a low temperature of, for example, 100°C or lower, preferably 80°C or lower, and/or ultraviolet irradiation is obtained.

In order to cure the curable resin composition by heating at a low temperature of, for example, 100°C or lower, preferably 80°C or lower, and/or ultraviolet irradiation, the component (B) in the curable resin composition is preferably 0.1 to 10.0 parts by mass, more preferably 0.5 to 8 parts by mass, and still more preferably 1.0 to 5 parts by mass based on 100 parts by mass of the component (A).

The component (C) in the curable resin composition is preferably 0.1 to 15 parts by mass, more preferably 0.2 to 10 parts by mass, and still more preferably 0.25 to 5 parts by mass based on 1 part by mass of the component (B). When the component (C) in the curable resin composition is 0.1 to 15 parts by mass based on 1 part by mass of the component (B), excess iodonium cations generated by decomposition of the iodonium salt are trapped, and generation of a gas that corrodes the adherend can be suppressed. The content of the component (C) is preferably 0.1 to 15 mass%, more preferably 0.1 to 10 mass%, and may be 0.5 to 10 mass% based on 100 mass% of the total amount of the curable resin composition.

The component (D) in the thermosetting resin composition is preferably 0 to 10.0 parts by mass, more preferably 0.1 to 8 parts by mass, and still more preferably 0.5 to 5 parts by mass based on 100 parts by mass of the component (A).

In a case where the thermosetting resin composition contains the component (D), a blending ratio of the component (B) to the component (D) (component (B):component (D)) is preferably about the same amount, and may be 25:75 to 75:25, 30:70 to 70:30, 40:60 to 60:40, or 50:50 in mass ratio.

The photosensitizer of the component (E) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The photoradical generator of the component (F) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The filler of the component (G) in the curable resin composition may be 0 to 50 mass%, 1 to 45 mass%, or 3 to 40 mass% based on 100 mass% of the total amount of the curable resin composition.

The above-mentioned optional component in the curable resin composition is 10 mass% or less, may be 0 to 10 mass%, 0.1 to 5 mass%, or 0.3~3 mass% based on 100 mass% of the total amount of the curable resin composition. As described above, at least one selected from the group consisting of the coupling agent (H) and the colorant (I) may be contained as the optional component.

### Method for producing curable resin composition

The curable resin composition can be produced by mixing the component (A), the component (B), and the component (C). The curable resin composition can be produced by further mixing the component (D), the component (E), the component (F), the component (G), the component (H), the component (I), and other optional components as necessary. The curable resin composition may be produced by mixing the components together with the additive as necessary. The components can be simultaneously or separately introduced into an appropriate mixer, and stirred and mixed while being melted by heating, if necessary, to obtain the curable resin composition. A method for producing the curable resin composition is not particularly limited. The curable resin composition can be produced by mixing raw materials to be the components with the mixer such as a mortar machine, a Henschel mixer, a roll mill, a three-roll mill, a ball mill, a planetary mixer, or a bead mill equipped with a stirring device and a heating device. In addition, the curable resin composition may be produced by appropriately combining two or more devices.

The curable resin composition is preferably liquid or paste at room temperature, for example, 20°C to 30°C. A viscosity of the curable resin composition is preferably 200 Pa·s or less, or may be 190 Pa·s or less, and is preferably 1 Pa·s or more, when measured immediately after preparing the resin composition (for example, within 30 minutes) and after the curable resin composition is left standing at room temperature, for example, 20°C to 30°C for a predetermined time using a Brookfield rotational viscometer (HBDV-I type or RVDV-I type, spindle: SC4-14 spindle, rotation speed: 50rpm, measurement temperature: 25°C). The viscosity of the curable resin composition at 20°C to 30°C measured by the above-described method may be 3 Pa·s to 10 Pa·s.

### Adhesive or sealing material

The curable resin composition can be used as the adhesive or the sealing material for fixing, bonding, or protecting components constituting the electronic device, the camera module, or the sensor module, and can also be used as the adhesive or the sealing material containing the curable resin composition.

### Method for supplying curable resin composition

The curable resin composition can be supplied using a jet dispenser, an air dispenser, or the like. In addition, it can be supplied by a known coating method (dip coating, spray coating, bar coater coating, gravure coating, reverse gravure coating, spin coater coating, and the like) and a known printing method (plate printing, carton printing, metal printing, offset printing, screen printing, gravure printing, flexographic printing, inkjet printing, and the like).

### Curing conditions of curable resin composition

The resin composition is thermosetting, and can be cured by heating at a temperature of 100°C or lower, preferably 80°C or lower, more preferably 75°C or lower, still more preferably 70°C or higher, preferably 45°C or higher, and more preferably 55°C or higher. A heating time for curing the curable resin composition is preferably 15 minutes or more and 4 hours or less, more preferably 30 minutes or more and 2 hours or less, and still more preferably 30 minutes or more and 60 minutes or less. In addition, the resin composition is ultraviolet curable, and can be cured preferably at a wavelength of 300 to 500 nm with an integrated light amount of 500 to 5000 mJ/cm².

### Cured product

The cured product is obtained by curing the curable resin composition, or the adhesive or the sealing material containing the curable resin composition. The cured product obtained by curing the curable resin composition at 80°C for 60 minutes has a glass transition temperature (Tg) of preferably 0°C to 150°C, more preferably 1°C to 120°C, still more preferably 2°C to 90°C, and yet still more preferably 3°C to 70°C, measured using a dynamic viscoelasticity measuring device (for example, DMA7100 or the like manufactured by Hitachi High-Tech Science Corporation). As the Tg of the cured product is lower, the number of functional group equivalents in the resin composition is smaller, and a crosslinking density is sparser. Therefore, in the cured product having a low Tg, the aryl iodide in the resin composition is likely to react with water vapor, and the corrosive gas is easily generated. In the curable resin composition, or the adhesive or the sealing material containing the curable resin composition, since the ion trapping agent traps the corrosive gas generated, it is considered that an effect of trapping the corrosive gas by the component (C) is more remarkable as the Tg is lower. The glass transition temperature can be measured with reference to a method in Examples described later.

### Semiconductor device and electronic device

As for the curable resin composition, in a case where the adhesive or the sealing material containing the curable resin composition is used for fixing, bonding, or protecting an electronic component, an electronic device containing the cured product obtained by curing the curable resin composition, or the adhesive or the sealing material containing the curable resin composition can be obtained. The electronic device may be a semiconductor device including a semiconductor element. Examples of the electronic device include a mobile phone, a smartphone, a notebook computer, a tablet terminal, and a camera module. The curable resin composition, or the adhesive or the sealing material containing the curable resin composition can be used for fixing, bonding, or protecting the electronic component, and can be cured by heating at a low temperature of 100°C or less, preferably 80°C or less, and it is possible to provide a highly reliable electronic device in which the corrosion of the adherend is suppressed.

### EXAMPLES

Hereinafter, the present invention will be described by way of Examples. The present invention is not limited to these Examples.

The components used in the curable resin compositions of Examples and Comparative Examples are shown below.

### Component (A): Cationically curable resin

### Component (A1): Epoxy resin having a ring skeleton in the molecule

(A1-1): AER9000 (manufactured by Asahi Kasei Corporation), the special epoxy resin containing the compound, in which the polyalkylene oxide structure is added to the epoxy resin and the bisphenol A skeleton, molecular weight is 760, epoxy group equivalent is 380 g/eq
(A1-2): EPICLON (registered trademark) EXA-850CRP (manufactured by DIC Corporation), the bisphenol A type epoxy resin, molecular weight is 344, epoxy group equivalent is 172 g/eq
(A1-3): ADEKA GLYCILOL (registered trademark) ED-509S (manufactured by ADEKA Corporation), p-tert-butyl phenyl glycidyl ether, molecular weight is 206, epoxy group equivalent is 206/eq
(A1-4): jER YX8000 (manufactured by Mitsubishi Chemical Corporation), hydrogenated bisphenol A diglycidyl ether, molecular weight is 410, epoxy group equivalent is 205 g/eq
(A1-5): CELLOXIDE (registered trademark) 2021P (manufactured by Daicel Corporation), 3',4'-epoxycyclomethyl-3,4-epoxycyclohexanecarboxylate, molecular weight is 260, epoxy group equivalent is 130 g/eq

### Component (A): Cationically curable resin

### Component (A2): Oxetane resin

(A2-1): OXT-221 (manufactured by Toagosei Co., Ltd.), 3-ethyl-3-{[(3-ethyloxetane-3-yl)methoxy]methyl}oxetane, molecular weight is 214, oxetane group equivalent is 107 g/eq
(A2-2): OXT-101 (manufactured by Toagosei Co., Ltd.), 3-ethyl-3-hydroxymethyloxetane (oxetane alcohol), molecular weight is 116, oxetane group equivalent is 116 g/eq

### Component (B): Acid generator containing iodonium salt

(B-1): Bluesil (registered trademark) PI2074 (manufactured by ELKEM SILICONES), 4-isopropyl-4'-methyldiphenyliodonium tetrakis(pentafluorophenyl)borate
(B-2): IK-1FG (manufactured by San-Apro Ltd.)

### Component (C): Ion trapping agent which contains at least one atom selected from the group consisting of Zr, Mg, and Al and is a layered compound

(C-1): IXEPLAS (registered trademark)-A1 (manufactured by Toagosei Co., Ltd.), component: Zr, Mg, Al-based, average particle size (primary particle size) of primary particles: 500 nm (catalog value)
(C-2): IXEPLAS (registered trademark)-A2 (manufactured by Toagosei Co., Ltd.), component: Zr, Mg, Al-based, average particle size (primary particle size) of primary particles: 200 nm (catalog value)
(C-3): Hydrotalcite (manufactured by FUJIFILM Wako Pure Chemical Corporation), average particle size of primary particles: 20 µm
(C-4): IXE (registered trademark)-700F (manufactured by Toagosei Co., Ltd.), component: Mg, Al-based, anion exchange system, average particle size (median diameter) of primary particles: 1.5 µm (1500 nm) (catalog value)
(C-5): SWMNA-010-1 (manufactured by Toda Kogyo Co., Ltd.), component: Mg, Al-based, anion exchange system, average particle size of primary particles (primary particle size): 300 nm
(C-6): SWMNA-050-1 (manufactured by Toda Kogyo Co., Ltd.), component: Mg, Al-based, anion exchange system, average particle size of primary particles (primary particle size): 60 nm
(C-7): IXEPLAS (registered trademark)-B1 (manufactured by Toagosei Co., Ltd.), component: Zr, Bi-based, average particle size of primary particles (primary particle size): 200 nm (catalog value)

### Component (C'): Ion trapping agent which does not contain at least one atom selected from the group consisting of Zr, Mg, and Al and is not a layered compound

(C'-8): IXE (registered trademark)-500 (manufactured by Toagosei Co., Ltd.), component: Bi-based, anion exchange system, average particle size (median diameter) of primary particles: 1.5 µm (1500 nm) (catalog value)

### Component (D): Organic peroxide

(D-1): Perkadox 24L (manufactured by Nouryon), dicetyl peroxydicarbonate, one-hour half-life temperature: 65°C, molecular weight is 570.9, SADT is 40°C
(D-2): PEROYL TCP (manufactured by NOF CORPORATION), di(4-tert-butylcyclohexyl) peroxydicarbonate, one-hour half-life temperature is 58°C, molecular is 398.5, SADT is 45°C
(D-3): PEROCTA O (manufactured by NOF CORPORATION), 1,1,3,3-tetramethylbutylperoxy-2-ethylhexanoate, one-hour half-life temperature is 84°C, molecular weight is 272.4, SADT is 40°C

### (E) Photosensitizer

(E-1): DETX, 2,4-diethylthioxanthone (manufactured by Nippon Kayaku Co., Ltd.)

### (F) Photoradical generator

(F-1): Omnirad (registered trademark) 184 (manufactured by IGM Resins), 1-hydroxycyclohexyl phenyl ketone

### (G) Filler

(G-1): SE5200SEE (manufactured by Admatechs Co., Ltd.), high purity synthetic spherical silica
(G-2): Cabosil (registered trademark) TS720 (manufactured by Cabot Japan K.K.), hydrophobic silica

### (H) Coupling agent

(H-1): Silane coupling agent, S530 (manufactured by JNC Corporation), 2-(3,4-epoxycyclohexyl)ethyltrimethoxysilane

### (I) Colorant

(I-1): Titanium black 13M (manufactured by Mitsubishi Materials Electronic Chemicals Co., Ltd.)

### (Examples 1 to 18, Comparative Examples 1 to 4)

A curable resin composition was prepared by mixing components in amounts according to blending ratios shown in Tables 1 to 3 using a three-roll mill. In Tables 1 to 3, numbers indicating the blending ratios of the components contained in the curable resin compositions represent parts by mass unless otherwise specified. In Tables, each component is mainly indicated by a symbol of a product name or a trade name. In Tables, the symbol "-" indicates that there is no corresponding item.

In Examples and Comparative Examples, characteristics of the curable resin composition and the cured product were measured as follows. Results are shown in Tables 1 to 3.

### Average particle size of primary particles of ion trapping agent

The average particle size of the primary particles of the ion trapping agent refers to an arithmetic average value of 50 arbitrary primary particles observed with a scanning electron microscope (SEM) and measured by SEM image analysis of an obtained SEM image. In a case where a commercially available product is used as the ion trapping agent of the component (C), the average particle size of the primary particles may be a catalog value.

### Preparation of cured product

Each of the curable resin compositions of Examples 1 to 7, 11 to 16, and 18 and Comparative Examples 1 to 4 was irradiated using a UV LED irradiation device AC475 manufactured by Excelitas Technologies Corp. with an integrated light amount of 2000 mJ/cm² (measured with UIT-250 (connected with a light receiver UVD-365) manufactured by Ushio Inc.), and then heated at 80°C for 60 minutes using a blower dryer to obtain a cured product. Each of the curable resin compositions of Examples 8 to 10 and 17 was heated at 80°C for 60 minutes using a blower dryer to obtain a cured product. The following measurement was performed for each cured product. Results are shown in Tables 1 to 3.

### Glass transition temperature (Tg) of cured product

Measurement was performed according to Japanese Industrial Standard JIS C6481. Specifically, first, a silicone-based release agent was applied to a glass plate having a thickness of 3 mm. Spacers (obtained by stacking heat-resistant tapes) were arranged at two locations thereon so that a film thickness when cured was 400±150 µm. Next, the curable resin composition was applied between the spacers, and the glass plate was sandwiched between other glass plates having a surface coated with a silicone-based release agent so as not to catch bubbles. Each of the curable resin compositions of Examples 1 to 7, 11 to 16, and 18 and Comparative Example 1 to 4 was subjected to UV curing treatment by UV irradiation using a UV LED irradiation device AC475 manufactured by Excelitas Technologies Corp. with an integrated light amount of 2000 mJ/cm2 (measured with UIT-250 (connected with a light receiver UVD-365) manufactured by Ushio Inc.), to obtain a cured product obtained by curing each of the curable resin compositions. Each of the curable resin compositions of Examples 8 to 10 and 17 was heated using a blower dryer to obtain a cured product obtained by curing each of the curable resin compositions. Finally, these cured products were peeled off from the glass plate coated with the silicone-based release agent, and then cut into a predetermined size (length: 10 mm, width: 40 mm) with a cutter to obtain a test piece. Note that a cut was smoothed with sandpaper. An initial Tg of the cured product was measured by a tensile method using a dynamic thermomechanical measuring device (DMA) (manufactured by Seiko Instruments Inc.) in a range of -20°C to 200°C, a frequency of 10 Hz, a heating rate of 3°C/min, a strain amplitude of 5 µm. The Tg was determined by measuring storage modulus (E') and loss modulus (E") of the cured product, and determining a peak temperature of dielectric tangent (tan δ) calculated from E"/E' as Tg.

### Discoloration property (discoloration evaluation): Heating

A resin composition having a size of 6mmφ (diameter: 6 mm) and a thickness of 600 µm was applied onto a copper-plated glass epoxy substrate (NEMA or ANSI standard FR4 substrate) having a width of 3 cm, a height of 3 cm, and a thickness of 1 mm by stencil printing. Thereafter, the substrate was thermally cured at 80°C for 60 minutes in a blower dryer. The obtained test piece was allowed to stand in a thermo-hygrostat at a temperature of 85°C and a humidity of 85% for 500 hours. The test piece was taken out from the thermo-hygrostat, and whether copper around the cured resin composition was discolored was visually observed. In a case where discoloration was observed, a length (unit: mm) from the cured product to a discolored portion was measured. Discoloration property obtained using the test piece was defined as discoloration property after heating. The discoloration property after heating is preferably 1 mm or less. The discoloration property is more preferably 0.5 mm or less, and still more preferably 0.1 mm or less.

### Discoloration property (discoloration evaluation): Ultraviolet irradiation (UV: 365 nm)

A resin composition having a size of 6mmφ (diameter: 6 mm) and a thickness of 600 µm was applied onto a copper-plated glass epoxy substrate (NEMA or ANSI standard FR4 substrate) having a width of 3 cm, a height of 3 cm, and a thickness of 1 mm by stencil printing. Thereafter, the resin composition was cured using a UV LED irradiation device AC475 manufactured by Excelitas Technologies Corp. with an integrated light amount of 2000 mJ/cm² (measured with UIT-250 (connected with a light receiver UVD-365) manufactured by Ushio Inc.) from a direction perpendicular to a surface to which the resin composition was applied. The obtained test piece was allowed to stand in a thermo-hygrostat at a temperature of 85°C and a humidity of 85% for 500 hours. The test piece was taken out from the thermo-hygrostat, and whether copper around the cured resin composition was discolored was visually observed. In a case where discoloration was observed, a length (unit: mm) from the cured product to a discolored portion was measured. The discoloration property obtained using the test piece was defined as discoloration property after ultraviolet irradiation. The discoloration property after ultraviolet irradiation is preferably 1 mm or less. The discoloration property is more preferably 0.5 mm or less, and still more preferably 0.1 mm or less.

### Discoloration property (discoloration evaluation): Heating and ultraviolet irradiation (UV: 365 nm)

A resin composition having a size of 6mmφ (diameter: 6 mm) and a thickness of 600 µm was applied onto a copper-plated glass epoxy substrate (NEMA or ANSI standard FR4 substrate) having a width of 3 cm, a height of 3 cm, and a thickness of 1 mm by stencil printing. Thereafter, the resin composition was cured using a UV LED irradiation device AC475 manufactured by Excelitas Technologies Corp. with an integrated light amount of 2000 mJ/cm² (measured with UIT-250 (connected with a light receiver UVD-365) manufactured by Ushio Inc.) from a direction perpendicular to a surface to which the resin composition was applied. Further, the substrate was thermally cured at 80°C for 60 minutes in a blower dryer. The obtained test piece was allowed to stand in a thermo-hygrostat at a temperature of 85°C and a humidity of 85% for 500 hours. The test piece was taken out from the thermo-hygrostat, and whether copper around the cured resin composition was discolored was visually observed. In a case where discoloration was observed, a length (unit: mm) from the cured product to a discolored portion was measured. The discoloration property obtained using the test piece was defined as discoloration property after heating and ultraviolet irradiation. The discoloration property after heating and ultraviolet irradiation is preferably 1 mm or less. The discoloration property is more preferably 0.5 mm or less, and still more preferably 0.1 mm or less.

### Discoloration property (discoloration evaluation): Evaluation

A case where the discoloration was not observed in any of the case of heating, the case of ultraviolet (UV) irradiation, and the case of heating and ultraviolet (UV) irradiation was evaluated as "G (Good) ". In any evaluation, in a case where the discoloration was 1 mm or less, it was evaluated as "A (Average) ". A case where discoloration more than 1 mm was observed in one of the cases of heating and ultraviolet (UV) irradiation, it was evaluated as "B (Bad) ". A case where the component (E) or the component (F) was not contained and the film was not cured by ultraviolet irradiation was evaluated as "-".

**[Table 1]**

| | | | | Example 1 | Example 2 | Example 3 | Example 4 | Example 5 | Example 6 | Example 7 |
|---|---|---|---|---|---|---|---|---|---|---|
| (A) | (A1) | (A1-1) | AER9000 | - | 45.35 | 29.95 | 32.49 | - | 47.02 | 47.02 |
| | | (A1-2) | EXA-850CRP | 27.78 | - | - | - | - | - | - |
| | | (A1-3) | ED-509S | - | - | - | 5.87 | 23.9 | - | - |
| | | (Al-4) | YX8000 | 33.12 | 9.79 | 26.93 | 11.69 | 23.79 | - | - |
| | | (A1-5) | 2021P | - | 6.21 | - | 3.71 | - | 6.43 | 6.43 |
| | (A2) | (A2-1) | OXT-221 | - | 2.55 | 5.62 | 6.14 | 6.21 | 7.95 | 7.95 |
| | | (A2-2) | OXT-101 | - | - | - | 3 | - | - | - |
| (B) | (B-1) | | P12074 | 1 | 1 | - | - | 1 | 1 | 4 |
| | (B-2) | | IK-1FG | - | - | 2 | 1 | - | - | - |
| (C) | (C-1) | | IXEPLAS-A1 | 0.1 | 0.5 | 1 | 5 | 10 | - | - |
| | (C-2) | | IXEPLAS-A2 | - | - | - | - | - | 3 | 3 |
| | (C-3) | | Hydrotalcite | - | - | - | - | - | - | - |
| | (C-4) | | IXE-700F | - | - | - | - | - | - | - |
| | (C-5) | | SWMNA-010-1 | - | - | - | - | - | - | - |
| | (C-6) | | SWMNA-050-1 | - | - | - | - | - | - | - |
| | (C-7) | | IXEPLAS-B1 | - | - | - | - | - | - | - |
| (C') | (C'-8) | | IXE-500 | - | - | - | - | - | - | - |
| (D) | (D-1) | | Perkadox24L | 2 | - | - | - | - | - | - |
| | (D-2) | | PEROYL TCP | - | 1 | 1 | 1 | 1 | 1 | 1 |
| | (D-3) | | PEROCTA O | - | - | - | - | 0.5 | - | - |
| (E) | (E-1) | | DETX | 0.1 | 0.1 | 0.1 | 0.1 | 0.1 | 0.1 | 0.1 |
| (F) | (F-1) | | Omnirad184 | - | - | - | - | - | - | - |
| (G) | (G-1) | | SE5200SEE | 30 | 30 | 30 | 30 | 30 | 30 | 25.5 |
| | (G-2) | | TS720 | 3 | 3 | 3 | - | 3 | 3 | 3 |
| (H) | (H-1) | | S530 | 2.5 | 0.5 | 0 | 0 | 0.5 | 0.5 | 2 |
| (I) | (I-I) | | Titanium black 13M | 0.4 | - | 0.4 | - | - | - | - |
| TOTAL | | | | 100 | 100 | 100 | 100 | 100 | 100 | 100 |
| Glass transition temperature Tg (°C) | | | | 128.0 | 38.3 | 43.4 | 40.1 | 70.9 | 29.1 | 29.3 |
| Discoloration evaluation | | Heating | | None | None | None | None | None | None | None |
| | | Heating and UV irradiation (365nm) | | None | None | None | None | None | None | None |
| | | UV irradiation (365nm) | | None | None | None | None | None | None | None |
| | | Evaluation | | G | G | G | G | G | G | G |

**[Table 2]**

| | | | | Example 8 | Example 9 | Example 10 | Example 11 | Example 12 | Example 13 | Example 14 | Example 15 |
|---|---|---|---|---|---|---|---|---|---|---|---|
| (A) | (A1) | (A1-1) | AER9000 | 19.61 | 19.61 | 19.61 | 19.61 | 19.61 | 19.61 | 19.61 | 59.9 |
| | | (A1-2) | EXA-850CRP | - | - | - | - | - | - | - | - |
| | | (A1-3) | ED-509S | - | - | - | - | - | - | - | - |
| | | (A1-4) | YX8000 | 31.75 | 31.75 | 31.75 | 31.75 | 31.75 | 31.75 | 31.75 | - |
| | | (A1-5) | 2021P | - | - | - | - | - | - | - | - |
| | (A2) | (A2-1) | OXT-221 | 33.14 | 33.14 | 33.14 | 33.14 | 33.14 | 33.14 | 33.14 | - |
| | | (A2-2) | OXT-101 | - | - | - | - | - | - | - | - |
| (B) | (B-1) | | PI2074 | 1 | 1 | 1 | 1 | 1 | 1 | 1 | 2 |
| | (B-2) | | IK-1FG | - | - | - | - | - | - | - | - |
| (c) | (C-1) | | IXEPLAS-A1 | - | - | - | - | - | - | - | - |
| | (C-2) | | IXEPLAS-A2 | - | - | - | - | - | - | - | 2 |
| | (C-3) | | Hydrotalcite | 3 | - | - | 3 | - | - | - | - |
| | (C-4) | | IXE-700F | - | 3 | - | - | 3 | - | - | - |
| | (C-5) | | SWMNA-010-1 | - | - | 3 | - | - | 3 | - | - |
| | (C-6) | | SWMNA-050-1 | - | - | - | - | - | - | 3 | - |
| | (C-7) | | IXEPLAS-B1 | - | - | - | - | - | - | - | - |
| (C') | (C'-8) | | IXE-500 | - | - | - | - | - | - | - | - |
| (D) | (D-1) | | Perkadox24L | - | - | - | - | - | - | - | - |
| | (D-2) | | PEROYL TCP | 1 | 1 | 1 | 1 | 1 | 1 | 1 | 2 |
| | (D-3) | | PEROCTA O | - | - | - | - | - | - | - | - |
| (E) | (E-1) | | DETX | - | - | - | 0.1 | 0.1 | 0.1 | - | 0.1 |
| (F) | (F-1) | | Omnirad184 | - | - | - | - | - | - | 1 | - |
| (G) | (G-1) | | SE5200SEE | - | - | - | - | - | - | - | 30 |
| | (G-2) | | TS720 | 10 | 10 | 10 | 10 | 10 | 10 | 10 | 3 |
| (H) | (H-1) | | S530 | 0.5 | 0.5 | 0.5 | 0.5 | 0.5 | 0.5 | 0.5 | 1 |
| (I) | (I-1) | | Titanium black 13M | - | - | - | - | - | - | - | - |
| TOTAL | | | | 100 | 100 | 100 | 100 | 100 | 100 | 101 | 100 |
| Glass transition temperature Tg (°C) | | | | 84.5 | 96.2 | 96.5 | 84.5 | 96.2 | 96.5 | 96.2 | 10.0 |
| Discoloration evaluation | | Heating | | None | None | None | None | None | None | None | None |
| | | Heating and UV irradiation (365nm) | | - | - | - | None | None | None | None | None |
| | | UV irradiation (365nm) | | - | - | - | None | None | None | None | None |
| | | Evaluation | | G | G | G | G | G | G | G | G |

**[Table 3]**

| | | | | Example 16 | Example 17 | Example 18 | Comparative Example 1 | Comparative Example 2 | Comparative Example 3 | Comparative Example 4 |
|---|---|---|---|---|---|---|---|---|---|---|
| (A) | (A1) | (A1-1) | AER9000 | - | 19.61 | 47.02 | 47.02 | 47.02 | 47.02 | 47.02 |
| | | (A1-2) | EXA-850CRP | - | - | - | - | - | - | - |
| | | (A1-3) | ED-509S | - | - | - | - | - | - | - |
| | | (A1-4) | YX8000 | 59.9 | 31.75 | - | - | - | - | - |
| | | (A1-5) | 2021P | - | - | 6.43 | 6.43 | 6.43 | 6.43 | 6.43 |
| | (A2) | (A2-1) | OXT-221 | - | 33.14 | 7.95 | 7.95 | 7.95 | 7.95 | 7.95 |
| | | (A2-2) | OXT-101 | - | - | - | - | - | - | - |
| (B) | (B-1) | | PI2074 | 2 | 1 | 4 | 1 | 1 | 4 | 4 |
| | (B-2) | | IK-1FG | - | - | - | - | - | - | - |
| (C) | (C-1) | | IXEPLAS-A1 | - | 3 | - | - | - | - | - |
| | (C-2) | | IXEPLAS-A2 | 2 | - | - | - | - | - | - |
| | (C-3) | | Hydrotalcite | - | - | - | - | - | - | - |
| | (C-4) | | IXE-700F | - | - | - | - | - | - | - |
| | (C-5) | | SWMNA-010-1 | - | - | - | - | - | - | - |
| | (C-6) | | SWMNA-050-1 | - | - | - | - | - | - | - |
| | (C-7) | | IXEPLAS-B1 | - | - | 3 | - | - | - | - |
| ) | (C'-8) | | IXE-500 | - | - | - | - | 3 | - | 3 |
| (D) | (D-1) | | Perkadox24L | - | - | - | - | - | - | - |
| | (D-2) | | PEROYL TCP | 2 | 1 | 1 | 1 | 1 | 1 | 1 |
| | (D-3) | | PEROCTA O | - | - | - | - | - | - | - |
| | (E-1) | | DETX | 0.1 | - | 0.1 | 0.1 | 0.1 | 0.1 | 0.1 |
| | (F-1) | | Omnirad184 | - | - | - | - | - | - | - |
| (G) | (G-1) | | SE5200SEE | 30 | - | 25.5 | 33 | 30 | 28.5 | 25.5 |
| | (G-2) | | TS720 | 3 | 10 | 3 | 3 | 3 | 3 | 3 |
| | (H-1) | | S530 | 1 | 0.5 | 2 | 0.5 | 0.5 | 2 | 2 |
| | (I-1) | | Titanium black 13M | - | - | - | - | - | - | - |
| TOTAL | | | | 100 | 100 | 100 | 100 | 100 | 100 | 100 |
| Glass transition temperature Tg (°C) | | | | 117.0 | 96.1 | 29.0 | 28.7 | 28.7 | 29.1 | 29.2 |
| Discoloration evaluation | | Heating | | None | None | 1 mm | 1 mm | 4 mm | 2 mm | 3 mm |
| | | Heating and UV irradiation (365nm) | | None | - | 0.7 mm | 3.5 mm | 0.4 mm | 2 mm | 2.4 mm |
| | | UV irradiation (365nm) | | None | - | 0.6 mm | 3.5 mm | 0.4 mm | 2 mm | 2.3 mm |
| | | Evaluation | | G | G | A | B | B | B | B |

As shown in Tables 1 to 3, the cured product of each of the curable resin compositions of Example 1 to 17 was not discolored and corrosion of an adherend was suppressed even in a case of being heated at a low temperature of 80°C or even in a case of being irradiated with ultraviolet rays having a peak wavelength of 365 nm. The discoloration of the cured product of the curable resin composition of Example 18 was suppressed to 1 mm or less even in a case of being heated at a low temperature of 80°C or even in a case of being irradiated with ultraviolet rays having a peak wavelength of 365 nm.

As shown in Table 3, the discoloration of the cured product of each of the curable resin compositions of Comparative Examples 1 to 4 containing no ion trapping agent of the component (C) or containing an ion trapping agent of the component (C') not containing at least one atom selected from the group consisting of Zr, Mg, and Al was observed, and corrosion of an adherend was not suppressed in a case of being heated at a low temperature of 80°C or irradiated with ultraviolet rays having a peak wavelength of 365 nm.

### INDUSTRIAL APPLICABILITY

The curable resin composition according to the present invention can be suitably used as the adhesive or the sealing material for fixing, bonding, or protecting the components constituting the electronic device. The resin composition, the adhesive or the sealing material containing the resin composition, a cured product obtained by curing a die attach agent, and the electronic device containing the cured product of the embodiment of the present invention can be used for, for example, a mobile phone, a smartphone, a notebook computer, a tablet terminal, a camera module, a sensor module, and the like.

## Claims

1. A curable resin composition comprising the following components (A) to (C):
(A) a cationically curable resin;
(B) an acid generator containing an iodonium salt; and
(C) an ion trapping agent containing at least one atom selected from the group consisting of Zr, Mg, and Al.

2. The curable resin composition according to claim 1, wherein the component (C) is 0.1 to 15 parts by mass based on 1 part by mass of the component (B).

3. The curable resin composition according to claim 1 or 2, wherein the component (C) is a both ion exchange type ion trapping agent.

4. The curable resin composition according to any one of claims 1 to 3, wherein primary particles of the component (C) have an average particle size of 30 nm to 3000 nm.

5. The curable resin composition according to any one of claims 1 to 4, wherein the component (A) comprises at least one selected from the group consisting of:
(A1) an epoxy resin having an epoxy group equivalent of 100 g/eq to 1000 g/eq and having a ring skeleton in a molecule of the epoxy resin; and
(A2) an oxetane resin.

6. The curable resin composition according to any one of claims 1 to 5, further comprising (D) an organic peroxide.

7. The curable resin composition according to any one of claims 1 to 6, wherein iodonium salt contained in the component (B) is an iodonium salt compound represented by the following Formula (1):
Ar¹-I⁺-Ar^{2.}Z⁻ (1)
(in Formula (1), Ar¹ and Ar² are each independently a substituted or unsubstituted aryl group, and Z⁻ is an anion).

8. The curable resin composition according to claim 7, wherein Z⁻ in Formula (1) is BF₄⁻, SbF₆⁻, AsF₆⁻, B(C₆F₅)₄⁻, Ga(C₆F₅)₄⁻, C(CF₃SO₂)₃⁻, [P(R^{F})ₐF'₆₋ₐ]⁻, [C(R^{F}SO₂)₃]⁻, or [N(R^{F}SO₂)₂]⁻ (where R^{F}s are each independently an alkyl group in which at least a part of hydrogen atoms is substituted with a fluorine atom, a is an integer of 0 to 5, and in a case where a is an integer of 2 or more, a plurality of R^{F}s are the same or different from each other).

9. An adhesive or a sealing material comprising the curable resin composition according to any one of claims 1 to 8.

10. A cured product obtained by curing the curable resin composition according to any one of claims 1 to 8, or the adhesive or the sealing material according to claim 9.

11. A semiconductor device comprising the cured product according to claim 10.

12. An electronic device comprising the cured product according to claim 10.
